# EUROPÄISCHE PATENTSCHRIFT

(11) **EP 2 223 337 B1**
(45) Veröffentlichungstag und Bekanntmachung des Hinweises auf die Patenterteilung: **29.08.2018**
(21) Anmeldenummer: 08865108.8
(22) Anmeldetag: 11.12.2008
(51) Int. Cl.: H01L 25/075, H01L 33/44, H01L 51/52, H01L 33/60

(54) **OPTOELEKTRONISCHES BAUELEMENT UND HERSTELLUNGSVERFAHREN FÜR EIN OPTOELEKTRONISCHES BAUELEMENT**
OPTOELECTRONIC COMPONENT AND PRODUCTION METHOD FOR AN OPTOELECTRONIC COMPONENT
COMPOSANT OPTOÉLECTRONIQUE ET PROCÉDÉ DE FABRICATION POUR UN COMPOSANT OPTOÉLECTRONIQUE

(30) Priorität: 21.12.2007 DE 102007062045; 21.04.2008 DE 102008019902
(43) Veröffentlichungstag der Anmeldung: 01.09.2010
(73) Patentinhaber: OSRAM Opto Semiconductors GmbH, 93055 Regensburg (DE)
(72) Erfinder: WEGLEITER, Walter, 93152 Nittendorf (DE); STATH, Norbert, 93049 Regensburg (DE); BRAUNE, Bert, 93173 Wenzenbach (DE); WEIDNER, Karl, 81245 München (DE); REBHAN, Matthias, 85521 Riemerling (DE); WULKESCH, Hans, 81739 München (DE)
(74) Vertreter: Epping - Hermann - Fischer
(86) Internationale Anmeldenummer: PCT/DE2008/002067
(87) Internationale Veröffentlichungsnummer: WO 2009/079985

(56) Entgegenhaltungen:
- EP-A2- 1 592 074
- WO-A-03/012884
- DE-A1- 10 339 985
- JP-A- S6 471 187
- JP-A- S60 253 286
- US-A1- 2006 055 309
- US-A1- 2006 082 297
- US-A1- 2006 145 164
- US-A1- 2006 214 579

## Beschreibung

Die Erfindung betrifft ein optoelektronisches Bauelement mit einem Trägerelement und wenigstens zwei auf einer ersten Seite des Trägerelements benachbart zueinander angeordnete Elemente mit jeweils mindestens einem optisch aktiven Bereich zum Erzeugen elektromagnetischer Strahlung.

Optoelektronische Bauelemente mit zwei oder mehr benachbart angeordneten Elementen zum Erzeugen elektromagnetischer Strahlung sind bekannt. Insbesondere im Beleuchtungsbereich, in dem verhältnismäßig hohe Energiedichten ausgestrahlter elektromagnetischer Strahlung erreicht werden sollen, wird oft eine Vielzahl von auf einem gemeinsamen Trägerelement angeordneten Leuchtelementen verwendet.
In manchen Anwendungsgebieten, beispielsweise bei aktiven Matrixanzeigen oder auch in der KFZ-Beleuchtungstechnik, sollen das Nebenleuchten benachbarter Elemente (auch Übersprechen genannt) und/oder Lichtleitereffekte so gering wie möglich gehalten werden. Ein Nebenleuchten benachbarter Elemente führt zu einer Verringerung des Kontrasts, was für diese Anwendungen von Nachteil sein kann. Beispielsweise ist es für Beleuchtungseinheiten eines KFZ-Scheinwerfers eine scharfe Abgrenzung von solchen Elementen, die einem Abblendlicht zugeordnet sind, und solchen Elementen, die einem Fernlichtbetrieb zugeordnet sind, erforderlich. JP S6471187 A offenbart eine lichtemittierende Diodenanordnung, wobei jeder Chip eine Anzahl von lichtemittierenden Punkten aufweist. Die Endflächen von zwei benachbarten Chips liegen einander gegenüber. Die Endflächen sind mit Photoabsorptionsfilmen ausgestattet.

JP 60253286 offenbart eine lichtemittierende Anordnung, wobei die lichtemittierenden Elemente durch Vertiefungen bis zu einem Substrat voneinander getrennt sind. Eine isolierende Schicht ist auf der Oberfläche aufgebracht und weist Ausschnitte auf, durch die jedes lichtemittierende Element Licht emittiert. Auf der isolierenden Schicht sind Elektrodenschichten aufgebracht, die eine seitliche Transmission des erzeugten Lichtes unterbinden. Aufgabe der vorliegenden Erfindung ist es, ein optoelektronisches Bauelement der oben genannten Art bereitzustellen, bei dem ein Nebenleuchten benachbarter Elemente mit jeweils mindestens einem optisch aktiven Bereich zum Erzeugen elektromagnetischer Strahlung unterbunden oder zumindest stark reduziert wird. Darüber hinaus soll ein Herstellungsverfahren angegeben werden, das die Herstellung eines solchen optoelektronischen Bauelementes in einfacher Weise gestattet.
Die Aufgabe wird durch ein optoelektronisches Bauelement mit den Merkmalen des Patentanspruches 1 beziehungsweise durch ein Verfahren mit den Merkmalen des unabhängigen Verfahrensanspruchs gelöst. Vorteilhafte Weiterbildungen und Ausgestaltungen des Bauelements und des Verfahrens sind in den abhängigen Unteransprüchen aufgeführt. Der Offenbarungsgehalt der Patentansprüche wird hiermit ausdrücklich in die Beschreibung aufgenommen. Beispiele, die nicht unter die Begriffe der Definition von den unabhängigen Ansprüche fallen, sind kein Bestandteil der vorliegenden Erfindung, obwohl sie zum Teil in der Beschreibung als "Ausführungsformen" bezeichnet sind. Sie sind lediglich Beispiele, die für das Verständnis der vorliegenden Erfindung hilfreich sind. Ein optoelektronisches Bauelement gemäß der Erfindung weist eine zumindest teilweise auf einer der ersten Seite gegenüberliegende Oberfläche der wenigstens zwei benachbarten Elemente angeordnete, elektrisch isolierende Schutzschicht auf, wobei die Schutzschicht wenigstens in einem zwischen den wenigstens zwei benachbarten Elementen angeordneten ersten Bereich eine Transmission der von den optisch aktiven Bereichen erzeugbaren elektromagnetische Strahlung zumindest überwiegend unterbindet.

Durch Verwendung einer elektrisch isolierenden Schutzschicht, die eine Transmission der erzeugbaren elektromagnetische Strahlung zumindest überwiegend unterbindet, kann ein Nebenleuchten benachbarter Elemente weitgehend verringert bis vermieden werden.
Gemäß einer vorteilhaften Ausgestaltung ist die elektrisch isolierende Schutzschicht in dem ersten Bereich unterbrochen. Gemäß der Erfindung absorbiert die elektrisch isolierende Schutzschicht in dem ersten Bereich die elektromagnetische Strahlung, so dass diese im ersten Bereich für die elektromagnetische Strahlung undurchlässig ist. Ist Schutzschicht in dem ersten Bereich unterbrochen oder absorbiert sie die elektromagnetische Strahlung, findet keine oder nur eine wesentlich verminderte Transmission von dem ersten zu dem zweiten optisch aktiven Bereich mittels Wellenleitung in der Schutzschicht statt.
Gemäß einer vorteilhaften Ausgestaltung ist zwischen den wenigstens zwei benachbarten Elementen eine Vertiefung angeordnet. Gemäß einer weiteren vorteilhaften Ausgestaltung erstreckt sich die Vertiefung sich über die gesamte Höhe der wenigstens zwei Elemente. Durch die Vertiefung zwischen dem ersten und zweiten optisch aktiven Element, wird eine optische Kopplung der zwei benachbart angeordneten Element verringert, insbesondere wenn sich diese über die gesamte Höhe erstreckt.
Gemäß einer weiteren vorteilhaften Ausgestaltung ist in dem ersten Bereich ein reflektierendes Element angeordnet, dass zumindest teilweise in die Vertiefung hineinreicht. Gemäß einer weiteren Ausgestaltung füllt das reflektierende Element die Vertiefung in Richtung des Trägerelements vollständig aus. Das reflektierende Element wirft die von dem jeweiligen optisch aktiven Bereich erzeugte Strahlung zurück, so dass eine Anregung des jeweils anderen optisch aktiven Bereichs vermieden wird, insbesondere wenn das reflektierende Element die Vertiefung vollständig ausfüllt.
Gemäß einer weiteren Ausgestaltung umfasst das reflektierende Element eine galvanisch aufgebrachte Metallschicht. Gemäß einer weiteren Ausgestaltung ist die galvanisch aufgebrachte Metallschicht als Anschlusselement, beispielsweise als Kupfersäule, zum elektrischen Anschließen wenigstens eines der optisch aktiven Bereiche ausgeführt. Dies hat den Vorteil, dass das reflektierende Element zusammen mit anderen Herstellungsschritten, etwa dem Aufbringen einer Anschlusskontakts, einfach hergestellt werden kann.
Gemäß einer weiteren vorteilhaften Ausgestaltung dringt die Schutzschicht in Richtung des Trägerelementes zumindest teilweise in die Vertiefung ein. Durch Eindringen der Schutzschicht in die Vertiefung wird eine Blendenwirkung der Schutzschicht erreicht.
Gemäß einer weiteren vorteilhaften Ausgestaltung füllt die Schutzschicht die Vertiefung in Richtung des Trägerelements vollständig aus. Hierdurch wird eine verbesserte optische Trennung der benachbarten Elemente bewirkt.

Gemäß der Erfindung ist auf wenigstens einem zweiten Bereich der Schutzschicht eine elektrisch leitende Anschlussschicht zum Zuführen einer elektrischen Spannung zu den wenigstens zwei optisch aktiven Bereichen angeordnet. Durch Anordnung einer elektrisch leitenden Anschlussschicht auf der Schutzschicht kann der elektrische Anschluss der wenigstens zwei optisch aktiven Bereiche vereinfacht werden.

Gemäß einer weiteren vorteilhaften Ausgestaltung ist die Schutzschicht in dem zweiten Bereich für die von den optisch aktiven Bereichen erzeugte elektromagnetische Strahlung zumindest überwiegend undurchlässig. Durch eine derartige Ausgestaltung können ungewollte Reflektionen von der Anschlussschicht zurück zu den optisch aktiven Bereichen verringert werden.

Gemäß einer weiteren vorteilhaften Ausgestaltung ist auf dem Trägerelement wenigstens eine elektrisch leitende Kontaktfläche zum elektrischen Anschließen wenigstens eines der optisch aktiven Bereiche angeordnet. Durch Verwendung einer elektrisch leitenden Kontaktfläche kann die elektrische Kontaktierung der optisch aktiven Bereiche weiter vereinfacht werden.

Gemäß einer weiteren vorteilhaften Ausgestaltung ist in wenigstens einem dritten Bereich der Schutzschicht eine fotolumineszente Konversionsschicht angeordnet, die elektromagnetische Strahlung einer ersten Wellenlänge absorbiert und elektromagnetischen Strahlung einer zweiten Wellenlänge emittiert. Durch Verwendung einer fotolumineszenten Konversionsschicht in einem dritten Bereich der Schutzschicht wird das Strahlungsprofil der wenigstens zwei benachbarten Elemente bedarfsgerecht angepasst.

Gemäß einer weiteren vorteilhaften Ausgestaltung sind die wenigstens zwei benachbarten Elemente jeweils als Lumineszenzdiodenstruktur, insbesondere als eine LED- oder OLED-Struktur, ausgebildet. Die Verwendung von LED- oder OLED-Strukturen erlaubt eine einfache und effiziente Erzeugung von elektromagnetischer Strahlung durch die wenigstens zwei benachbarten Elemente.

Gemäß einer weiteren vorteilhaften Ausgestaltung sind die Lumineszenzdioden als Dünnfilm-Leuchtdiodenchips ausgebildet. Durch Verwendung substratloser Halbleiterschichtenstapel können besonders dünne optoelektronische Bauelemente gefertigt werden.

Gemäß einer weiteren vorteilhaften Ausgestaltung sind die wenigstens zwei benachbarten Elemente jeweils als Oberflächenstrahler ausgebildet. Die Verwendung von Oberflächenstrahler ermöglicht eine besonders vorteilhafte Strahlbildung.

Gemäß einer weiteren vorteilhaften Ausgestaltung ist eine Mehrzahl von Elementen mit jeweils wenigstens einem optisch aktiven Bereich auf der ersten Seite des Trägerelements angeordnet, wobei die Mehrzahl der Elemente eine Matrixstruktur bildet. Durch Verwendung einer Mehrzahl von Elementen in einer Matrixstruktur sind durch das Bauelement vielfältige Leuchtmuster und Anzeigefunktionen erzeugbar.

Gemäß einer weiteren vorteilhaften Ausgestaltung sind zumindest Teile der Schutzschicht als farbige, insbesondere als schwarze, Folie ausgebildet. Die Verwendung von farbigen Folien gestattet eine besonders einfache Herstellung und Aufbringung der Schutzschicht.

Gemäß einer weiteren vorteilhaften Ausgestaltung umfasst die farbige Folie ein Polymer, insbesondere ein Silikon. Polymerfolien lassen sich in einer Vielzahl von Farben mit gewünschten Eigenschaften herstellen. Silikonmaterial weist eine hohe Beständigkeit unter Einwirkung kurzwelliger elektromagnetischer Strahlung auf und eignet sich daher insbesondere bei der Verwendung mit optisch aktiven Bereichen, die elektromagnetische Strahlung im blauen oder ultravioletten Bereich abstrahlen.

Gemäß einer weiteren vorteilhaften Ausgestaltung weist die Folie wenigstens jeweils einen Ausschnitt im Bereich der wenigstens zwei optisch aktiven Bereiche auf. Durch den Ausschnitt im Bereich der wenigstens zwei optisch aktiven Bereiche wirkt die Folie als einfach herzustellendes Blendenelement für eine darunter liegende Strahlungsfläche.

Ein Herstellungsverfahren für ein optoelektronisches Bauelement gemäß der Erfindung weist folgende Schritte auf:
- Bereitstellen eines Trägerelements,
- benachbartes Anordnen wenigstens zweier Elemente mit jeweils wenigstens einem optisch aktiven Bereich zum Erzeugen einer elektromagnetischen Strahlung auf einer ersten Seite des Trägerelements und
- Aufbringen einer elektrisch isolierenden Schutzsicht auf eine der ersten Seite gegenüberliegende Oberfläche der wenigstens zwei benachbarten Elemente, wobei die Schutzschicht in wenigstens einem zwischen den wenigstens zwei benachbarten Elementen angeordneten, ersten Bereich eine Transmission der von den optisch aktiven Bereichen erzeugbaren elektromagnetische Strahlung zumindest überwiegend unterbindet.

Durch die oben genannten Verfahrensschritte wird ein optoelektronisches Bauelement mit mindestens zwei benachbarten Elementen hergestellt, bei dem ein Nebenleuchten der benachbarten Elemente zumindest überwiegend verhindert wird.

Gemäß einer vorteilhaften Ausgestaltung umfasst das Anordnen der wenigstens zwei benachbarten Elemente zusätzlich ein Herstellen eines ersten elektrischen Kontakts zwischen Kontaktflächen des Trägerelements und den wenigstens zwei benachbarten Elementen. Durch ein gemeinsames Herstellen eines ersten elektrischen Kontaktes zusammen mit dem Anordnen der wenigstens zwei Elemente auf dem Trägerelement wird der Anschluss der wenigstens zwei benachbarten Elemente vereinfacht.

Gemäß einer weiteren vorteilhaften Ausgestaltung umfasst das Verfahren zusätzlich ein Erstellen wenigstens eines Ausschnitts in der Schutzschicht, ein Aufbringen einer elektrisch leitenden Anschlussschicht auf der Schutzschicht und ein Herstellen eines zweiten elektrischen Kontakts zwischen der Anschlussschicht und den wenigstens zwei benachbarten Elementen im Bereich des wenigstens einen Ausschnitts. Durch das Aufbringen einer Anschlussschicht und Herstellen eines Kontakts im Bereich des Ausschnitts kann die elektrische Kontaktierung der wenigstens zwei benachbarten Elemente weiter vereinfacht werden.

Gemäß einer weiteren vorteilhaften Ausgestaltung umfasst das Aufbringen der elektrisch isolierenden Schutzschicht ein flächiges Aufbringen eines transparenten Isolationsmaterials auf das Trägerelement mit den wenigstens zwei Elementen. Ein flächiges Aufbringen des transparenten Isolationsmaterials kann herstellungstechnisch besonderes einfach durchgeführt werden.

Gemäß einer vorteilhaften Ausgestaltung wird die elektrisch isolierende Schutzschicht in dem ersten Bereich unterbrochen. Durch ein Unterbrechen der Schutzschicht in dem Bereich, der einer optischen Trennung zwischen den zwei Elementen dient, wird eine technisch einfache Herstellung des optoelektronischen Bauelementes ermöglicht.

Gemäß einer alternativen Ausgestaltung wird das transparente Isolationsmaterial in dem wenigstens einen ersten Bereichs durch Einbringen von mindestens einem ersten Fremdstoff, beispielsweise eines Farbstoffes oder eines strahlungsabsorbierenden oder reflektierenden Füllstoffes, eingefärbt. Ein Einfärben eines zunächst transparenten Isolationsmaterials in dem Bereich, der einer optischen Trennung zwischen den zwei Elementen dient, ermöglicht ebenfalls eine technisch einfache Herstellung des optoelektronischen Bauelementes.

Gemäß einer weiteren vorteilhaften Ausgestaltung wird das transparente Material auf das Trägermaterial aufgeschleudert. Hierzu kann mit Vorteil ein konventionelles Schleuderverfahren angewendet werden.

Gemäß einer weiteren vorteilhaften Ausgestaltung umfasst das Herstellungsverfahren zusätzlich ein Bilden eines Konversionselements in wenigstens einem dritten Bereich der Schutzschicht durch Einbringen von mindestens einem zweiten Fremdstoff, beispielsweise ein organischer oder anorganischer Leuchtstoff, in das transparente Isolationsmaterial. Durch das Einbringen eines zweiten Fremdstoffes kann ein Konversionselement, beispielsweise eine fotolumineszente Konversionsschicht, besonders einfach hergestellt werden.

Gemäß einer weiteren vorteilhaften Ausgestaltung umfasst das Aufbringen der elektrisch isolierenden Schutzschicht ein Aufbringen eines die elektromagnetische Strahlung absorbierendes oder reflektierendes Isolationsmaterials auf die erste Seite des Trägerelements, wobei das Isolationsmaterial jeweils wenigstens einem Ausschnitt in zwei den wenigstens zwei benachbarten Elementen zugeordneten dritten Bereichen aufweist. Durch Aufbringen eines Isolationsmaterials mit wenigstens zwei Ausschnitten in der Schutzschicht wird auf technisch einfache Weise eine Blendenstruktur bereitgestellt. Dabei können die Ausschnitte vor oder nach dem Aufbringen des Isolationsmaterials erstellt werden. Hierzu eignet sich insbesondere die Verwendung einer farbigen Folie.

Gemäß einer weiteren vorteilhaften Ausgestaltung wird zwischen den wenigstens zwei benachbarten Elementen eine Vertiefung geformt. Die Vertiefung vermindert die optische Kopplung der benachbarten Elemente.

Gemäß einer weiteren vorteilhaften Ausgestaltung wird im Bereich der Vertiefung ein reflektierendes Element angeordnet. Das reflektierende Element verbessert die optische Entkopplung der benachbarten Elemente.

Gemäß einer weiteren vorteilhaften Ausgestaltung wird das reflektierende Element in der Vertiefung galvanisch abgeschieden. Auf diese Weise lässt sich das reflektieren Elemente verfahrenstechnisch besonders einfach herstellen.

Gemäß einer weiteren Ausgestaltung wird die elektrisch isolierende Schutzschicht mit Vorteil durch Laminieren auf die erste Seite aufgebracht wird.
Weitere Einzelheiten und Ausgestaltungen der Erfindung sind in den Unteransprüchen angegeben.
Die Erfindung wird nachfolgend anhand von Ausführungsbeispielen näher erläutert. In den dargestellten Ausführungsbeispielen werden identische Bezugszeichen für Elemente mit gleicher oder ähnlicher Funktion verwendet.
In den Figuren zeigen:
Figuren 1A und 1B ein optoelektronisches Bauelement gemäß einer Ausgestaltung der Erfindung,
Figur 2 ein optoelektronisches Bauelement gemäß einer weiteren Ausgestaltung der Erfindung,
Figur 3 ein optoelektronisches Bauelement gemäß einer weiteren Ausgestaltung,
Figur 4 ein optoelektronisches Bauelement gemäß einer weiteren Ausgestaltung und
Figur 5 ein Ablaufdiagramm eines Verfahrens zur Herstellung eines optoelektronischen Bauelementes.

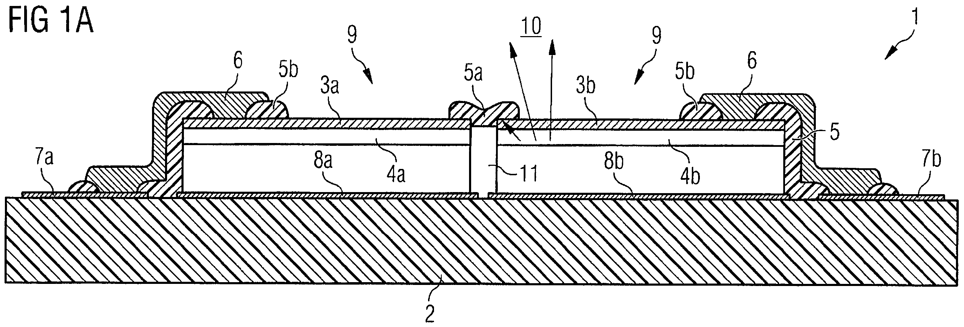

Figur 1A zeigt einen Querschnitt durch ein optoelektronisches Bauelement 1. Das optoelektronische Bauelement 1 weist ein Trägerelement 2 sowie zwei auf dem Trägerelement 2 angeordnete Elemente 3a und 3b auf. Jedes der Elemente 3a und 3b umfasst einen optisch aktiven Bereich 4a beziehungsweise 4b.

Beispielsweise handelt es sich bei dem Trägerelement 2 um ein Leiterplattenmaterial, auf dem zwei LED-Chips als benachbarte strahlungsemittierende Elemente 3a und 3b aufgelötet sind. Alternativ kann das Trägerelement 2 auch als Keramikträger ausgeführt sein, auf dem die Elemente 3a und 3b festgeklebt sind. Die Verwendung eines Keramikträgers anstelle eines Leiterplattenmaterials erhöht insbesondere die Wärmeleitfähigkeit des Trägerelementes 1 und eignet sich daher für besonders leistungsfähige Elemente 3a und 3b. Auch die Verwendung eines Aufwachssubstrates, beispielsweise eines Germanium-Wafers, als Trägerelement ist möglich.

Der optisch aktive Bereich 4a beziehungsweise 4b kann beispielsweise ein Bereich eines Halbleiterschichtenstapels sein, in dem Majoritäts- und Minoritätsladungsträger einer Halbleiterdiodenstruktur beim Anlegen einer Betriebsspannung miteinander rekombinieren und elektromagnetische Strahlung aussenden.

Bei einer beispielhaften Ausgestaltung sind die Elemente 3a und 3b Dünnfilm-Leuchtdiodenchips, beispielsweise auf Basis eines Nitrid-Verbindungshalbleitermaterials oder Halbleitermaterialsystems wie beispielsweise InGaN oder InGaAIP. Bei dieser Ausgestaltung sind eine erste und eine zweite Anschlussschicht zumindest stellenweise zwischen der Halbleiterschichtenfolge und dem Trägerelement 2 angeordnet. Ein Dünnfilm-Leuchtdiodenchip zeichnet sich durch mindestens eines der folgenden charakteristischen Merkmale aus:
- an einer zu dem Trägerelement 2, insbesondere einem Trägersubstrat, hingewandten Hauptfläche der strahlungserzeugenden Halbleiterschichtenfolge, bei der es sich insbesondere um eine strahlungserzeugende Epitaxie-Schichtenfolge handelt, ist eine reflektierende Schicht aufgebracht oder ausgebildet, die zumindest einen Teil der in der Halbleiterschichtenfolge erzeugten elektromagnetischen Strahlung 10 in diese zurückreflektiert;
- bei dem Trägerelement 2 handelt es sich nicht um ein Wachstumssubstrat, auf dem die Halbleiterschichtenfolge epitaktisch gewachsen wurde, sondern um ein separates Trägerelement 2, das nachträglich an der Halbleiterschichtenfolge befestigt wurde;
- die Halbleiterschichtenfolge weist eine Dicke im Bereich von 20 *µ*m oder weniger, insbesondere im Bereich von 10 *µ*m oder weniger auf;
- die Halbleiterschichtenfolge ist frei von einem Aufwachssubstrat. Vorliegend bedeutet "frei von einem Aufwachssubstrat, dass ein gegebenenfalls zum Aufwachsen benutztes Aufwachssubstrat von der Halbleiterschichtenfolge entfernt oder zumindest stark gedünnt ist. Insbesondere ist es derart gedünnt, dass es für sich oder zusammen mit der Epitaxie-Schichtenfolge alleine nicht freitragend ist. Der verbleibende Rest des stark gedünnten Aufwachssubstrats ist insbesondere als solches für die Funktion eines Aufwachssubstrates ungeeignet; und
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, das heißt, sie weist ein möglichst ergodisch stochastisches Streuverhalten auf.
Ein Grundprinzip eines Dünnfilm-Leuchtdiodenchips ist beispielsweise in der Druckschrift I. Schnitzer et al., Appl. Phys. Lett. 63 (16) 18. Oktober 1993, Seiten 2174 - 2176 beschrieben. Beispiele für Dünnfilm-Leuchtdiodenchips sind in den Druckschriften EP 0905797 A2 und WO 02/13281 A1 beschrieben.
Ein Dünnfilm-Leuchtdiodenchip ist in guter Näherung ein Lambert'scher Oberflächenstrahler und eignet sich von daher beispielsweise gut für die Anwendung in einem Scheinwerfer, etwa einem Kraftfahrzeugscheinwerfer.
Die zwei benachbarten Elemente 3a und 3b sind in dem Ausführungsbeispiel gemäß Figur 1A zumindest teilweise mit einer elektrisch isolierenden Schutzschicht 5 bedeckt. Die elektrisch isolierende Schutzschicht 5 besteht im Ausführungsbeispiel aus einem ersten Bereich 5a der zumindest teilweise zwischen den zwei benachbarten Elementen 3a und 3b angeordnet ist, sowie zwei zweiten Bereichen 5b auf den voneinander abgewandten Seiten der Elemente 3a und 3b.
Auf den zweiten Bereichen 5b ist eine Anschlussschicht 6 angeordnet die eine Oberfläche der Elemente 3a und 3b mit Anschlusskontakten 7a und 7b auf dem Trägerelement 2 verbindet. Auf dem Trägerelement 2 sind des Weiteren zwei Kontaktflächen 8a und 8b angeordnet, über die die Unterseite der Elemente 3a und 3b mit einer Betriebsspannung versorgt werden können.

Die zwei Elemente 3a und 3b sind durch eine Vertiefung 11 voneinander getrennt, wobei der erste Bereich 5a der Schutzschicht 5 teilweise in die Vertiefung 11 hineinragt.

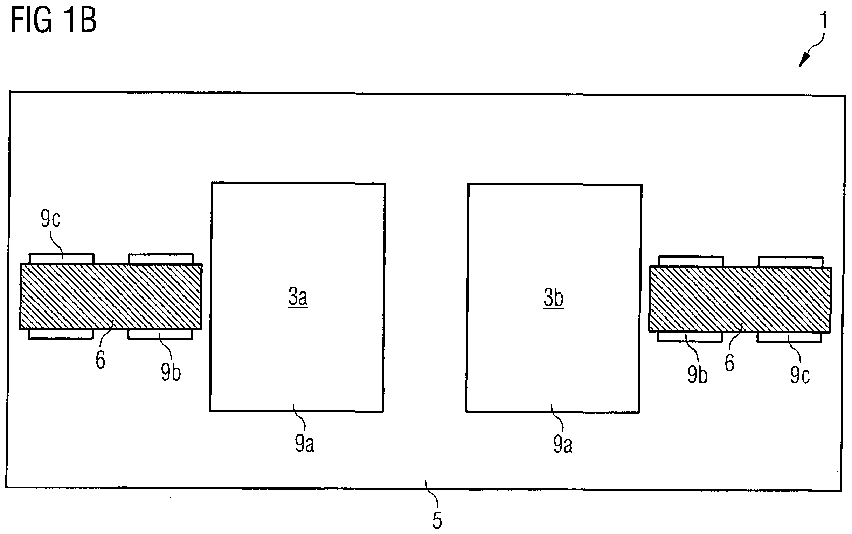

Figur 1B zeigt eine Aufsicht auf das Bauelement 1, in der die Schutzschicht 5 besonders gut zu erkennen ist.

Im Ausführungsbeispiel wird die Schutzschicht 5 durch eine Polymerfolie gebildet, aus der in einem Bereich über den Elementen 3a und 3b zwei Ausschnitte 9a ausgeschnitten beziehungsweise ausgestanzt sind. Durch die Ausschnitte 9a in der Schutzschicht 5 tritt im eingeschalteten Zustand des Bauelements elektromagnetische Strahlung 10, insbesondere sichtbares Licht, z.B. mit Wellenlängen im Bereich zwischen 400 und 800 Nanometer, aus.

Des Weiteren umfasst die Schutzschicht 5 weitere Ausschnitte 9b und 9c, durch die die Anschlussschicht 6 die darunter liegenden Elemente 3a und 3b beziehungsweise die Anschlusskontakte 7a und 7b elektrisch kontaktiert. Im dargestellten Ausführungsbeispiel umfasst die Anschlussschicht 6 zwei getrennte Leiterbahnelemente, die beispielsweise durch bekannte fotolithographische Verfahren auf das Bauelement 1 aufgetragen wurden. Selbstverständlich ist es auch möglich, eine gemeinsame Anschlussschicht für beide Elemente 3a und 3b zu verwenden.

Bei der Polymerfolie handelt es sich bevorzugt um eine farbige oder schwarze Folie, die im Wellenlängenbereich der von den optisch aktiven Bereichen 4a und 4b ausgestrahlten elektromagnetischen Strahlung 10 ganz oder zumindest überwiegend undurchlässig ist. Bevorzugt absorbiert die Schutzschicht 5 im ersten Bereich 5a mehr als 50 Prozent der auf sie treffenden elektromagnetischen Strahlung 10, besonders bevorzugt mehr als 75 Prozent, zum Beispiel 90 Prozent, bevorzugt mehr als 95 Prozent, zum Beispiel 98 Prozent oder mehr. Elektromagnetische Strahlung 10, die mit einem zu großen Abstrahlwinkel bezüglich der Vertikalen zum Trägerelement 2 ausgestrahlt wird, wird daher überwiegend in dem ersten Bereich 5a beziehungsweise in den zweiten Bereichen 5b der Schutzschicht 5 von der Polymerfolie absorbiert. Dies ist insbesondere durch den linken Pfeil anhand des in der Figur 1A rechten Elementes 3b dargestellt.

Wie aus den Figuren 1A und 1B deutlich wird, dient die Schutzschicht 5 einer doppelten Funktion. Zum Einen bildet sie Blendenelemente für die von den optisch aktiven Bereichen 4a und 4b ausgestrahlten elektromagnetischen Strahlung 10. Darüber hinaus isoliert sie die Elemente 3a und 3b außerhalb der gewünschten Kontaktbereiche von der Anschlussschicht 6. Das optoelektronische Bauelement 1 gemäß den Figuren 1A und 1B ist besonders einfach herstellbar und weist ein im Vergleich zu herkömmlichen optoelektronischen Bauelementen mit benachbarten optisch aktiven Bereichen 4a und 4b verbessertes Kontrastverhältnis auf.

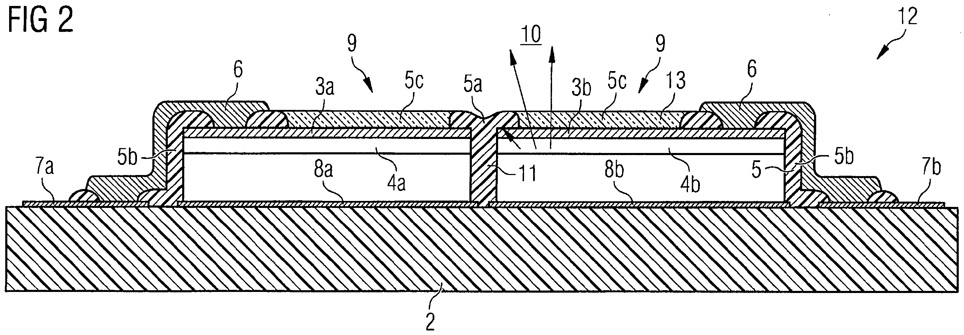

Figur 2 zeigt ein optoelektronische Bauelement 12 gemäß einer weiteren Ausgestaltung der Erfindung. Das optoelektronische Bauelement 12 ist ähnlich wie das optoelektronische Bauelement 1 gemäß der Figur 1 aufgebaut. Insbesondere weist es ebenfalls ein Trägerelement 2 auf, auf dem zwei benachbarte Elemente 3a und 3b, die jeweils einen optisch aktiven Bereich 4a und 4b umfassen, angeordnet sind.

Anders als das optoelektronische Bauelement 1 ist auf das optoelektronische Bauelement 12 gemäß Figur 2 ganzflächig eine Schutzschicht 5 aufgetragen. Beispielsweise besteht die Schutzschicht 5 aus einem zunächst klaren Polymermaterial, das im Bereich der Elemente 3a und 3b auf das Trägerelement 2 aufgeschleudert ist.

Die Schutzschicht 5 des optoelektronischen Bauelementes 12 weist einen ersten Bereich 5a, zwei zweite Bereiche 5b sowie zwei dritte Bereiche 5c auf. Der erste Bereich 5a sowie die zwei zweiten Bereiche 5b, die im linken beziehungsweise rechten Teil der Elemente 3a und 3b angeordnet sind, sind durch Einbringen von ersten Fremdstoffen eingefärbt. Insbesondere können sie durch das Einbringen von Farbstoffpartikeln für Licht einer Wellenlänge der von den optisch aktiven Bereichen 4a und 4b ausgesandten elektromagnetischen Strahlung 10 ganz oder zumindest überwiegend undurchlässig gemacht sein.

Für das Auf- oder Einbringen der Fremdstoffe eignen sich beispielsweise Siebdruck- oder Diffusionsverfahren, wobei nicht zu färbende Bereiche der Schutzschicht 5 über geeignete Masken abgedeckt werden. Anstelle des Einbringens von Fremdstoffen können auch fotolithographische Verfahren Anwendung finden, bei denen Bereiche der Schutzschicht 5 über geeignete Masken belichtet und durch einen nachfolgenden Entwicklungsprozess verfärbt werden.

Im in der Figur 2 dargestellten Ausführungsbeispiel ist die Vertiefung 11 zwischen dem ersten Element 3a und dem zweiten Element 3b vollständig von dem gefärbten Polymermaterial des ersten Bereiches 5a der Schutzschicht 5 ausgefüllt. Somit wird ein Nebenleuchten der benachbarten Elemente 3a und 3b weitestgehend, vorzugsweise vollständig verhindert.

Die dritten Bereiche 5c der Schutzschicht 5 sind auf der vorderseitigen Oberfläche der Elemente 3a und 3b angeordnet, durch die die elektromagnetische Strahlung der optisch aktiven Bereiche 4a und 4b austreten soll. Gemäß einer Ausgestaltung wird das Material der Schutzschicht 5 in den dritten Bereichen 5c verfestigt, wobei es seine transparente Eigenschaft behält. Die dritten Bereiche 5c der Schutzschicht 5 dienen somit als Schutzschicht für die empfindlichen Elemente 3a und 3b und erlauben einen weitgehend ungehinderten Austritt der elektromagnetischen Strahlung 10.

Gemäß einer vorteilhaften Ausgestaltung dienen die dritten Bereiche 5c des Weiteren als fotolumineszente Konversionselemente 13. Beispielsweise kann eine Polymerschicht durch Einbringen von organischem oder anorganischem Leuchtstoff in ein Konversionselement 13 umgewandelt werden. Das Konversionselement 13 gemäß Figur 2 absorbiert dabei einen Teil der elektromagnetischen Strahlung 10 einer ersten Wellenlänge der optisch aktiven Bereiche 4a und 4b und strahlt elektromagnetische Strahlung einer anderen Wellenlänge aus.

Beispielsweise können die optisch aktiven Bereiche 4a und 4b Licht einer verhältnismäßig kurzen Wellenlänge, beispielsweise blaues Licht, ausstrahlen, das durch die Konversionselemente 13 zumindest teilweise in Licht einer längeren Wellenlänge, beispielsweise gelbes oder grünes und rotes Licht, umgewandelt wird. Durch die Überlagerung von elektromagnetischer Strahlung kurzer Wellenlänge und größerer Wellenlänge entsteht für einen Beobachter des optoelektronischen Bauelementes 12 der Eindruck eines mischfarbigen, beispielsweise weißen Leuchtelementes. Auf diese Weise kann das optoelektronische Bauelement 12 an ein vorgegebenes Anforderungsprofil angepasst werden.

Anstelle der in der Figur 2 durch Einbringen von Leuchtstoff hergestellter Konversionselemente 13 können selbstverständlich auch separate Konversionsplättchen auf einem optoelektronischen Bauelement angeordnet werden.

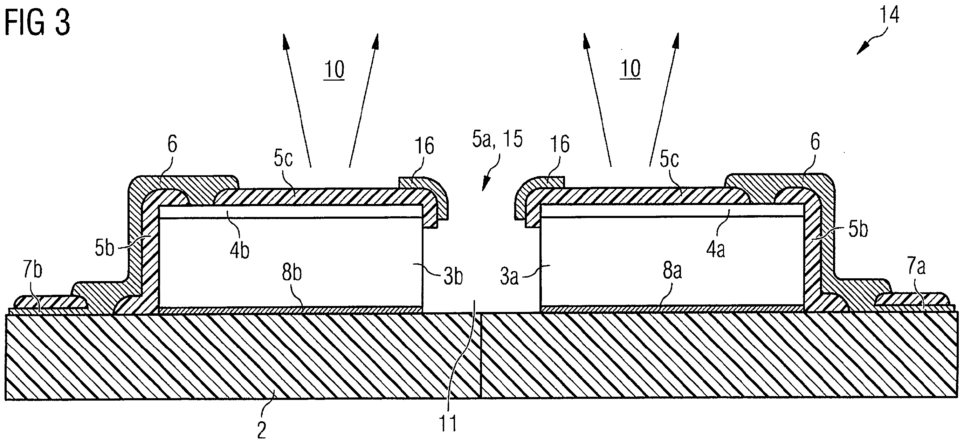

Figur 3 zeigt eine weitere Ausgestaltung eines optoelektronischen Bauelementes 14. Das optoelektronische Bauelement 14 umfasst ein Trägerelement 2, auf dem zwei Elemente 3a und 3b mit jeweils einem optisch aktiven Bereich 4a beziehungsweise 4b benachbart angeordnet sind. Die Elemente 3a und 3b sind auf elektrisch leitfähigen Kontaktflächen 8a beziehungsweise 8b angeordnet, die den optisch aktiven Bereich 4a beziehungsweise 4b mit einem ersten elektrischen Spannungspotential verbinden. Die benachbarten Elemente 3a und 3b sind derart auf den Trägerelement 2 angeordnet, dass zwischen ihnen eine Lücke in Form einer Vertiefung 11 verbleibt.

Über den beiden Elementen 3a und 3b ist eine elektrisch isolierende Schutzschicht 5 angeordnet, die im Ausführungsbeispiel aus jeweils zwei seitlichen Bereichen 5b und einem Deckelbereich 5c an der Oberfläche der optisch aktiven Bereiche 4a beziehungsweise 4b besteht. Die elektrisch isolierende Schutzschicht 5 schützt die Elemente 3a und 3b vor mechanischen und elektrischen Störungen. Insbesondere isoliert sie das Element 3a und das Element 3b von einer elektrisch leitenden Anschlussschicht 6, welche die optisch aktiven Bereichen 4a beziehungsweise 4b mit einem zweiten elektrischen Spannungspotential verbindet.

Im Ausführungsbeispiel handelt es sich bei dem optoelektronischen Bauelement 14 um einen Oberflächenstrahler, der in der Figur 3 dargestellten Anordnung elektromagnetische Strahlung 10, beispielsweise Licht im sichtbaren Bereich, nach oben abgibt, also im Wesentlichen senkrecht von dem Trägerelement 2 weg. Die elektrisch isolierende Schutzschicht besteht beispielsweise aus einer transparenten Polymerfolie, welche die elektromagnetische Strahlung 10 überwiegend ungehindert durchlässt.

Um ein Nebenleuchten der benachbart angeordneten optisch aktiven Bereiche 4a und 4b zu vermeiden, wurde die elektrisch isolierende Schutzschicht 5 in einem Zwischenbereich 5a zwischen den beiden Elementen 3a und 3b unterbrochen. Somit wird eine unbeabsichtigte optische Wellenleiterfunktion der elektrisch isolierenden Schutzschicht 5 von dem ersten optisch aktiven Bereich 4a zu dem zweiten optisch aktiven Bereich 4b oder umgekehrt vermieden. Beispielsweise kann eine Unterbrechung 15 dadurch hergestellt werden, dass eine Polymerfolie im Bereich der Vertiefung 11 durchtrennt wird. Hierzu eignen sich beispielsweise Laserschneidverfahren, bei denen ultrakurze, energiereiche Laserimpulse zur lokalen Auflösung der Schutzschicht 5 verwendet werden.

Um ein Nebenleuchten noch weiter zu unterdrücken, sind gemäß der dargestellten Ausgestaltung im Bereich der Unterbrechung 15 zusätzliche galvanische Spiegelschichten 16 auf der isolierenden Schutzschicht 5 angeordnet. Die Spiegelschichten 16 werfen von dem ersten und zweiten optisch aktiven Bereichen 4a und 4b seitlich ausgesandte elektromagnetische Strahlung 10 in Richtung der Quelle zurück und verhindern somit ein Nebenleuchten.

Die galvanische Spiegelschicht 16 kann beispielsweise zusammen mit der elektrisch leitenden Anschlussschicht 6 aufgebracht werden. Die galvanische Spiegelschicht 16 kann dabei vor oder nach Unterbrechung der isolierenden Schutzschicht 5 aufgebracht werden. Wird die galvanische Spiegelschicht 16 zuvor aufgebracht, sollte sie bevorzugt so dünn oder flexibel ausgestaltet werden, dass sie nach erfolgter Unterbrechung der Schutzschicht 5 zusammen mit dieser entlang der Seitenflächen der Elemente 3a und 3b heruntergeklappt werden kann. Die üblicherweise in einem galvanischen Herstellungsschritt verwendeten Metalle und Metalllegierungen weisen in der Regel die hierzu benötigte Flexibilität auf. Gegebenenfalls können die Schutzschicht 5 und/oder die Spiegelschicht 16 im Bereich der Knickstellen lokal erhitzt werden, um eine Durchbiegung zu erleichtern.

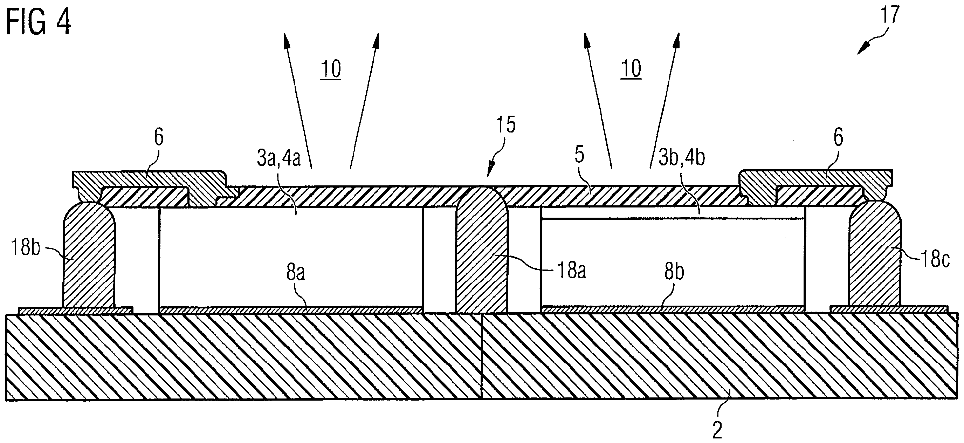

Figur 4 zeigt eine weitere Ausgestaltung eines optoelektronischen Bauelementes 17. Das optoelektronische Bauelement 17 umfasst wiederum ein Trägerelement 2 mit zwei darauf benachbart angeordneten Elementen 3a und 3b mit jeweils einem optisch aktiven Bereich 4a beziehungsweise 4b. Die benachbart angeordneten Elemente 3a und 3b sind jeweils auf einer zugeordneten Kontaktfläche 8a beziehungsweise 8b des Trägerelementes 2 angeordnet und strahlen elektromagnetische Strahlung 10 in einer Richtung aus, die im wesentlichen senkrecht zur Oberfläche des Trägerelementes 2 ist.

Um ein ungewünschtes Nebenleuchten der optisch aktiven Bereiche 4a und 4b in dem optoelektronischen Bauelement 17 zu verhindern, ist eine erste Kupfersäule 18a in einem Zwischenraum zwischen den Elementen 3a und 3b auf dem Trägerelement 2 angeordnet. Die Kupfersäule 18a kann beispielsweise mittels eines galvanischen Prozesses auf dem Trägerelement 2 abgeschieden werden.

Die Anordnung gemäß Figur 4 enthält des Weiteren zwei weitere Kupfersäulen 18b und 18c, die zur Versorgung der optisch aktiven Bereiche 4a beziehungsweise 4b mit einem Betriebsstrom dienen. Zu diesem Zweck ist eine elektrisch leitende Anschlussschicht 6 auf einer über den benachbart angeordneten Elementen 3a und 3b angeordnete elektrisch isolierende Schutzschicht 5 angeordnet. Selbstverständlich kann die erste Kupfersäule 18a auch die Funktion einer oder beider der Kupfersaulen 18b und 18c übernehmen.

Die elektrisch isolierende Schutzschicht 5 ist in dem Bereich der ersten Kupfersäule 18a durch diese unterbrochen. Dies verhindert eine Wellenleitung innerhalb der elektrisch isolierenden Schutzschicht 5 und somit eine Nebenleuchten der optisch aktiven Bereiche 4a und 4b. Gleichzeitig wirkt die Kupfersäule 18a auch als reflektierendes Element und verhindert somit eine direkte optische Kopplung der benachbart angeordneten Element 3a und 3b. Zur Verbesserung der mechanischen Stabilität kann der verbleibende Hohlraum zwischen dem Trägerelement 2 und der Schutzschicht 5 mit einem Füllmaterial aufgefüllt werden.

In dem in der Figur 4 dargestellten Ausführungsbeispiel kann die elektrisch isolierende Schutzschicht 5 beispielsweise durch Rolllaminieren auf das optoelektronische Bauelement 17 aufgetragen werden. Dies resultiert gegenüber anderen Herstellungsverfahren, wie beispielsweise der so genannten Vakuumlaminiertechnik, in einer einfacheren Herstellung. Gleichzeitig ist die Dicke der elektrisch isolierenden Schutzschicht 5 reduzierbar, beispielsweise auf eine Foliendicke von nur etwa 20 *µ*m. Die hat unter anderem den Vorteil, dass der Transmissionsgrad der Schutzschicht 5 erhöht wird und deren Materialkosten sich verringern.

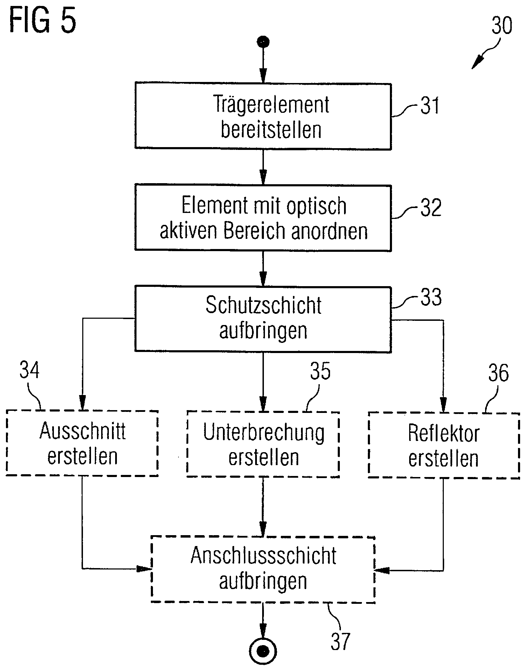

Figur 5 zeigt ein Ablaufdiagramm eines Verfahrens 30 zur Herstellung eines optoelektronischen Bauelementes.

In einem ersten Schritt 31 wird ein Trägerelement 2 bereitgestellt. Beispielsweise kann eine Leiterplatte mit darauf angeordneten Anschlusskontakten 7a und 7b und Kontaktflächen 8a und 8b bereitgestellt werden. Alternativ kann auch ein Keramik- oder sonstiges Trägerelement bereitgestellt werden, das zur mechanischen Befestigung, zum elektrischen Anschluss und/oder zur Kühlung von darauf anzuordnenden Elementen 3a, 3b dient.

In einem zweiten Schritt 32 werden wenigstens zwei Elemente 3a und 3b mit jeweils einem optisch aktiven Bereich 4a und 4b auf dem Trägerelement 2 angeordnet. Es ist auch möglich, die Elemente 3a und 3b epitaktisch direkt auf dem Trägerelement 2 aufzuwachsen.

Gemäß einer Ausgestaltung der Erfindung sind die Elemente 3a und 3b zumindest in einer Schicht miteinander verbunden. Beispielsweise kann eine Schicht eines Halbleiterschichtenstapels, der nur eine geringe Leitfähigkeit in horizontaler Richtung aufweist, zur mechanischen Verbindung der benachbarten Elemente 3a und 3b verwendet werden. Alternativ werden die Elemente 3a und 3b getrennt voneinander auf dem Trägerelement 2 angeordnet.

In einer bevorzugten Ausgestaltung werden die Elemente 3a und 3b auf Kontaktflächen 8a beziehungsweise 8b angeordnet und gleichzeitig mit der mechanischen Verbindung auch elektrisch mit dem Trägerelement 2 verbunden. Beispielsweise können Elemente 3a und 3b durch ein Lotmaterial im Bereich von Kontaktflächen 8a beziehungsweise 8b elektrisch und mechanisch verbunden werden.

Gemäß einer weiteren vorteilhaften Ausgestaltung werden eine Mehrzahl von Elementen 3 auf dem Trägerelement 2 angeordnet. Beispielsweise können zwei übereinander angeordnete Zeilen mit einer Mehrzahl von Elementen 3a und 3b auf einem gemeinsamen Trägerelement angeordnet werden, wobei alle Elemente einer ersten Zeile zum Bereitstellen eines Abblendlichtes und alle Elemente 3b der zweiten Zeile zur Bereitstellung eines Fernlichtes dienen.

In einem Schritt 33 wird auf dem Trägerelement 2, insbesondere im Bereich der Elemente 3a und 3b eine Schutzschicht 5 aufgebracht. Dabei kann die Schutzschicht 5 beispielsweise in Form einer Polymerfolie auf die Elemente 3a und 3b aufgeklebt oder laminiert werden. Alternativ kann auch ein flüssiges Material, beispielsweise ein klares Polymermaterial auf das Trägerelement 2 aufgeschleudert werden.

Gemäß einer Ausgestaltung ist die Schutzschicht 5 zumindest in einem ersten Bereich 5a für elektromagnetische Strahlung 10 der optisch aktiven Bereiche 4a und 4b undurchlässig. Gemäß einer alternativen Ausgestaltung ist die aufgebrachte Schutzschicht 5 zunächst durchlässig, wird in dem ersten Bereich 5a jedoch für elektromagnetische Strahlung 10 zumindest teilweise undurchlässig gemacht. Beispielsweise eignet sich hierfür das Einbringen von Fremdstoffen in den ersten Bereich 5a. Alternativ kann die Schutzschicht 5 vor oder nach dem Aufbringen in dem ersten Bereich 5a auch durchtrennt werden.

Sofern die Schutzschicht 5 die gesamte Oberfläche der Elemente 3a und 3b bedeckt und für elektromagnetische Strahlung 10 der optisch aktiven Bereiche 4a und 4b undurchlässig ist, müssen ein oder mehrere Transmissionsfenster, beispielsweise in Form von Ausschnitten, in die Schutzschicht 5 eingebracht werden. Dies wird in der Figur 5 als optional dargestellten Schritt 34 durchgeführt. Das Herstellen von Ausschnitten 9 kann im Falle einer lichtundurchlässigen Polymerfolie bereits vor dem Aufbringen der Folie auf die Elemente 3a und 3b durchgeführt werden. Im Falle einer aufgeschleuderten Schutzsicht 5 können Teile der Schutzschicht 5 in dritten Bereichen 5c entfernt oder durch geeignete Bearbeitung für elektromagnetische Strahlung 10 durchsichtig gemacht werden. Hierzu eignen sich auch Verfahren zum strukturierten Formen, Pressen oder Giessen der Schutzschicht 5, beispielsweise durch einen so genannten Boschmann-Prozess. Weitere Ausschnitte in der Schutzschicht 5 können zur elektrischen Kontaktierung der Elemente 3 von der Oberseite her vorgesehen werden.

Alternativ zur Einbringung von Fremdstoffen kann eine Schutzschicht 5 aus einem fotoempfindlichen Material, beispielsweise einem Silikonmaterial, in dem ersten, zweiten und/oder dritten Bereich 5a, 5b und/oder 5c eingefärbt werden. Hierzu können fotolithografische Verfahren verwendet werden, die entweder in einer Ein- oder Entfärbung ausgewählter Bereiche der Schutzschicht 5 mittels Belichtung führen. Alternativ können auch einzelne Bereiche einer fotoempfindlichen Schicht belichtet und fixiert und in einem späteren Entwicklungsschritt unfixierte Schichten entfernt werden.

In einem alternativen Verfahrensschritt 35 wird die elektrisch isolierende Schutzschicht in dem ersten Bereich 5a unterbrochen. Die Unterbrechung der elektrisch isolierenden Schutzschicht 5 kann beispielsweise durch Lasertrennverfahren oder auch mechanische Schneidverfahren erfolgen, wobei eine Durchtrennung vor oder nach Anordnung der Schutzschicht auf den wenigstens zwei benachbart angeordneten Elementen 3 durchgeführt werden kann. Eine vorherige Trennung hat den Vorteil, dass keine weiteren Verfahrensschritte nach Anordnen der Schutzschicht 5 auf den Elementen 3 mehr durchgeführt werden müssen und sich somit das Risiko einer Verschmutzung oder Beschädigung der optischen aktiven Bereiche 4 vermindert. Die nachträgliche Durchtrennung der Schutzschicht 5 besitzt den Vorteil, dass die Unterbrechung 15 bezogen auf die benachbart angeordneten Elemente 3 an der gewünschten Stelle und in demselben Herstellungsprozess durchgeführt werden kann.

In einem weiteren alternativen oder zusätzlichen Verfahrensschritt 36 wird ein reflektierendes Element zumindest teilweise in einem Zwischenraum zwischen den benachbart angeordneten Elementen 3 angeordnet. Beispielsweise kann eine Metallschicht vor oder nach Unterbrechung der Schutzschicht 5 auf der elektrisch isolierenden Schutzschicht 5 galvanisch abgeschieden werden. Alternativ ist es auch möglich, ein reflektierendes Element in einem Zwischenraum einzubringen, beispielsweise durch Abscheiden einer Kupfersäule 18a in einem Bereich einer Vertiefung 11 zwischen den Elementen 3a und 3b.

In einem weiteren Schritt 37 wird eine Anschlussschicht 6 auf zweite Bereiche 5b der Schutzschicht 5 aufgebracht. Durch Aufbringen der Anschlussschicht 6 wird eine Kontaktierung der Elemente 3a, 3b und somit der darin enthaltenen optisch aktiven Bereiche 4a und 4b von der Oberseite her ermöglicht. Darüber hinaus wirkt die Anschlussschicht 6 als zusätzliches Blendenelement der optisch aktiven Bereiche 4.
Es wird darauf hingewiesen, dass die in der Figur 5 dargestellte Abfolge von Arbeitsschritten nur beispielhaft ist und bezüglich ihrer Reihenfolge angepasst werden kann. Beispielsweise ist es möglich, eine Schutzschicht 5 zunächst auf die Elemente 3a und 3b aufzutragen, bevor diese auf dem Trägerelement 2 angeordnet werden.
Des Weiteren ist es für einen Fachmann offensichtlich, dass sämtliche in den Figuren 1A und 1B sowie den Figuren 2 bis 4 dargestellten Merkmale in nahezu beliebiger Weise miteinander kombiniert werden können.

## Patentansprüche

1. Optoelektronisches Bauelement (1, 12), aufweisend ein Trägerelement (2), wenigstens zwei auf einer ersten Seite des Trägerelements (2) benachbart angeordnete Elemente (3) mit jeweils mindestens einem optisch aktiven Bereich (4) zum Erzeugen elektromagnetischer Strahlung (10) und eine zumindest teilweise auf einer der ersten Seite gegenüberliegenden Oberfläche der wenigstens zwei benachbarten Elemente (3) angeordnete, elektrisch isolierende Schutzschicht (5), wobei die Schutzschicht (5) wenigstens in einem zwischen den wenigstens zwei benachbarten Elementen (3) angeordneten ersten Bereich (5a) eine Transmission der von den optisch aktiven Bereichen (4) erzeugbaren elektromagnetische Strahlung (10) zumindest überwiegend unterbindet, wobei die elektrisch isolierende Schutzschicht (5) in dem ersten Bereich (5a) die elektromagnetische Strahlung (10) absorbiert, **dadurch gekennzeichnet, dass**
auf wenigstens einem zweiten Bereich (5b) der Schutzschicht (5) eine elektrisch leitende Anschlussschicht (6) zum elektrischen Anschließen der wenigstens zwei optisch aktiven Bereiche (4) angeordnet ist.

2. Optoelektronisches Bauelement (1, 12) nach Anspruch 1,
**dadurch gekennzeichnet, dass**
die Schutzschicht (5) in dem zweiten Bereich (5b) für die von den optisch aktiven Bereichen (4) erzeugte elektromagnetische Strahlung (10) zumindest überwiegend undurchlässig ist.

3. Optoelektronisches Bauelement (12) nach einem der Ansprüche 1 oder 2, **dadurch gekennzeichnet, dass** in wenigstens einem dritten Bereich (5c) der Schutzschicht (5) ein fotolumineszentes Konversionselement (13) angeordnet ist, das elektromagnetische Strahlung (10) einer ersten Wellenlänge absorbiert und elektromagnetische Strahlung einer zweiten Wellenlänge emittiert.

4. Optoelektronisches Bauelement (14, 17) nach einem der Ansprüche 1 bis 3,
**dadurch gekennzeichnet, dass**
die elektrisch isolierende Schutzschicht (5) in dem ersten Bereich (5a) unterbrochen ist.

5. Optoelektronisches Bauelement (1, 12) nach Anspruch 1,
**dadurch gekennzeichnet, dass**
die elektrisch isolierende Schutzschicht (5) in dem ersten Bereich (5a) mehr als 75 Prozent der elektromagnetischen Strahlung (10) absorbiert.

6. Optoelektronisches Bauelement (1, 12, 14, 17) nach einem der Ansprüche 1 bis 5, **dadurch gekennzeichnet, dass** zwischen den wenigstens zwei benachbarten Elementen (3) eine Vertiefung (11) angeordnet ist.

7. Optoelektronisches Bauelement (1, 14, 17) nach Anspruch 6, **dadurch gekennzeichnet, dass**
die Vertiefung (11) sich über die gesamte Höhe der wenigstens zwei Elemente (3) erstreckt.

8. Optoelektronisches Bauelement (14, 17) nach Anspruch 7,
**dadurch gekennzeichnet, dass**
in dem ersten Bereich (5a) ein reflektierendes Element (16, 18a) angeordnet ist, dass zumindest teilweise in die Vertiefung (11) hineinreicht.

9. Optoelektronisches Bauelement (1, 12, 14) nach Anspruch 6 oder 7, **dadurch gekennzeichnet, dass** die elektrisch isolierende Schutzschicht (5) in Richtung des Trägerelements (2) zumindest teilweise in die Vertiefung (11) eindringt.

10. Optoelektronisches Bauelement (1, 12, 14, 17) nach einem der Ansprüche 1 bis 9, **dadurch gekennzeichnet, dass** eine Mehrzahl von Elementen (3) mit jeweils mindestens einem optisch aktiven Bereich (4) auf der ersten Seite des Trägerelements (2) angeordnet ist, wobei die Mehrzahl der Elemente (3) eine Matrixstruktur bildet.

11. Optoelektronisches Bauelement (1) nach einem der Ansprüche 1 bis 10, **dadurch gekennzeichnet, dass** zumindest Teile der Schutzschicht (5) als farbige, insbesondere schwarze, Folie ausgebildet sind.

12. Herstellungsverfahren (30) für ein optoelektronisches Bauelement (1, 12), umfassend:
- Bereitstellen eines Trägerelementes (2),
- benachbartes Anordnen wenigstens zweier Elemente (3) mit jeweils wenigstens einem optisch aktiven Bereich (4) zum Erzeugen einer elektromagnetischen Strahlung (10) auf einer ersten Seite des Trägerelements (2),
- Aufbringen einer elektrisch isolierenden Schutzschicht (5) auf eine der ersten Seite gegenüberliegende Oberfläche der wenigstens zwei benachbarten Elemente (3), wobei die Schutzschicht (5) in wenigstens einem zwischen den wenigstens zwei benachbarten Elementen (3) angeordneten ersten Bereich (5a) eine Transmission der von den optisch aktiven Bereichen (4) erzeugbaren elektromagnetische Strahlung (10) zumindest überwiegend unterbindet, wobei die elektrisch isolierende Schutzschicht (5) in dem ersten Bereich (5a) die elektromagnetische Strahlung (10) absorbiert, **gekennzeichnet durch** die Schritte:
- Erstellen wenigstens eines Ausschnitts (9) in der Schutzschicht (5),
- Aufbringen einer elektrisch leitenden Anschlussschicht (6) auf der Schutzschicht (5) und
- Herstellen eines zweiten elektrischen Kontakts zwischen der Anschlussschicht (6) und den wenigstens zwei benachbarten Elementen (3) im Bereich des wenigstens einen Ausschnitts (9).

13. Herstellungsverfahren (30) nach Anspruch 12, **dadurch gekennzeichnet, dass**
zwischen den wenigstens zwei benachbarten Elementen (3) eine Vertiefung (11) geformt wird.

## Claims

1. An optoelectronic component (1, 12), comprising a carrier element (2), at least two elements (3) arranged in an adjacent fashion on a first side of the carrier element (2) and each having at least one optically active region (4) for generating electromagnetic radiation (10), and an electrically insulating protective layer (5) arranged at least in part on a surface of the at least two adjacent elements (3) which lies opposite the first side, wherein the protective layer (5), at least in a first region (5a) arranged between the at least two adjacent elements (3) at least predominantly prevents a transmission of the electromagnetic radiation (10) which can be generated by the optically active regions (4), wherein the electrically insulating protective layer (5) absorbs the electromagnetic radiation (10) in the first region (5a), **characterized in that**, an electrically conductive connection layer (6) for electrically connecting the at least two optically active regions (4) is arranged on at least one second region (5b) of the protective layer (5).

2. The optoelectronic component (1, 12) as claimed in claim 1, **characterized in that** the protective layer (5), in the second region (5b), is at least predominantly opaque to the electromagnetic radiation (10) generated by the optically active regions (4).

3. The optoelectronic component (12) as claimed in claim 1 or 2, **characterized in that** a photoluminescent conversion element (13) is arranged in at least one third region (5c) of the protective layer (5), said conversion element absorbing electromagnetic radiation (10) having a first wavelength and emitting electromagnetic radiation having a second wavelength.

4. The optoelectronic component (14, 17) as claimed in any of claims 1 to 3, **characterized in that** the electrically insulating protective layer (5) is interrupted in the first region (5a).

5. The optoelectronic component (1, 12) as claimed in claim 1, **characterized in that** the electrically insulating protective layer (5) absorbs more than 75 percent of the electromagnetic radiation (10) in the first region (5a).

6. The optoelectronic component (1, 12, 14, 17) as claimed in any of claims 1 to 5, **characterized in that** a depression (11) is arranged between the at least two adjacent elements (3).

7. The optoelectronic component (1, 14, 17) as claimed in claim 6, **characterized in that** the depression (11) extends over the entire height of the at least two elements (3).

8. The optoelectronic component (14, 17) as claimed in claim 7, **characterized in that** a reflecting element (16, 18a) is arranged in the first region (5a), said reflecting element extending at least partly into the depression (11) .

9. The optoelectronic component (1, 12, 14) as claimed in claim 6 or 7, **characterized in that** the electrically insulating protective layer (5) penetrates at least partly into the depression (11) in a direction towards the carrier element (2).

10. The optoelectronic component (1, 12, 14, 17) as claimed in any of claims 1 to 9, **characterized in that** a plurality of elements (3) each having at least one optically active region (4) is arranged on the first side of the carrier element (2), wherein the plurality of elements (3) forms a matrix structure.

11. The optoelectronic component (1) as claimed in any of claims 1 to 10, **characterized in that** at least parts of the protective layer (5) are embodied as a colored, in particular black, foil.

12. A production method (30) for an optoelectronic component (1, 12), comprising:
- providing a carrier element (2),
- arranging in adjacent fashion at least two elements (3) each having at least one optically active region (4) for generating an electromagnetic radiation (10) on a first side of the carrier element (2),
- applying an electrically insulating protective layer (5) to a surface of the at least two adjacent elements (3) which lies opposite the first side, wherein the protective layer (5), in at least one first region (5a) arranged between the at least two adjacent elements (3), at least predominantly prevents a transmission of the electromagnetic radiation (10) which can be generated by the optically active regions (4), wherein the electrically insulating protective layer (5) absorbs the electromagnetic radiation (10) in the first region (5a), **characterized by** the steps:
- creating at least one cutout (9) in the protective layer (5),
- applying an electrically conductive connection layer (6) on the protective layer (5), and
- producing a second electrical contact between the connection layer (6) and the at least two adjacent elements (3) in the region of the at least one cutout (9) .

13. The production method (30) as claimed in claim 12, **characterized in that** a depression (11) is formed between the at least two adjacent elements (3).

## Revendications

1. Élément optoélectronique (1, 12), présentant un élément de support (2), au moins deux éléments (3) disposés dans le voisinage l'un de l'autre sur un premier côté de l'élément de support (2) avec au moins une zone optiquement active (4) respective pour générer un rayonnement électromagnétique (10) et une couche de protection (5) électriquement isolante disposée au moins partiellement sur une surface des au moins deux éléments voisins (3) opposée au premier côté, dans lequel la couche de protection (5) empêche au moins essentiellement dans une première zone (5a) située entre les au moins deux éléments voisins (3) une transmission du rayonnement électromagnétique (10) que les zones optiquement actives (4) sont susceptibles de générer, dans lequel la couche de protection (5) électriquement isolante absorbe le rayonnement électromagnétique (10) dans la première zone (5a), **caractérisé en ce qu'**une couche de raccordement (6) électriquement conductrice pour le raccordement électrique des au moins deux zones optiquement actives (4) est disposée sur au moins une deuxième zone (5b) de la couche de protection (5).

2. Élément optoélectronique (1, 12) selon la revendication 1, **caractérisé en ce que** la couche de protection (5) est au moins essentiellement imperméable dans la deuxième zone (5b) au rayonnement électromagnétique (10) généré par les zones optiquement actives (4).

3. Élément optoélectronique (12) selon l'une des revendications 1 ou 2, **caractérisé en ce qu'**un élément de conversion photoluminescent (13), qui absorbe le rayonnement électromagnétique (10) d'une première longueur d'ondes et émet un rayonnement électromagnétique d'une deuxième longueur d'ondes, est disposé dans au moins une troisième zone (5c) de la couche de protection (5).

4. Élément optoélectronique (14, 17) selon l'une des revendications 1 à 3, **caractérisé en ce que** la couche de protection (5) électriquement isolante est interrompue dans la première zone (5a).

5. Élément optoélectronique (1, 12) selon la revendication 1, **caractérisé en ce que** la couche de protection (5) électriquement isolante absorbe dans la première zone (5a) plus de 75 pour-cent du rayonnement électromagnétique (10).

6. Élément optoélectronique (1, 12, 14, 17) selon l'une des revendications 1 à 5, **caractérisé en ce qu'**une concavité (11) est disposée entre les au moins deux éléments voisins (3).

7. Élément optoélectronique (1, 14, 17) selon la revendication 6, **caractérisé en ce que** la concavité (11) s'étend sur l'ensemble de la hauteur des au moins deux éléments (3).

8. Élément optoélectronique (14, 17) selon la revendication 7, **caractérisé en ce qu'**un élément réfléchissant (16, 18a) qui pénètre au moins partiellement dans la concavité (11) est disposé dans la première zone (5a).

9. Élément optoélectronique (1, 12, 14) selon la revendication 6 ou 7, **caractérisé en ce que** la couche de protection (5) électriquement isolante pénètre au moins partiellement dans la concavité (11) dans le sens de l'élément de support (2).

10. Élément optoélectronique (1, 12, 14, 17) selon l'une des revendications 1 à 9, **caractérisé en ce qu'**une pluralité d'éléments (3) avec au moins une zone optiquement active (4) est disposée sur le premier côté de l'élément de support (2), dans lequel la pluralité d'éléments (3) constitue une structure matricielle.

11. Élément optoélectronique (1) selon l'une des revendications 1 à 10, **caractérisé en ce qu'**au moins des parties de la couche de protection (5) sont formées sous la forme d'un film coloré, en particulier noir.

12. Procédé de fabrication (30) d'un élément optoélectronique (1, 12), comprenant :
- la mise à disposition d'un élément de support (2),
- la disposition voisine d'au moins deux éléments (3) avec au moins une zone optiquement active (4) respective pour générer un rayonnement électromagnétique (10) sur un premier côté de l'élément de support (2),
- l'application d'une couche de protection (5) électriquement isolante sur une surface des au moins deux éléments voisins (3) opposée au premier côté, dans lequel la couche de protection (5) empêche au moins essentiellement dans une première zone (5a) située entre les au moins deux éléments voisins (3) une transmission du rayonnement électromagnétique (10) que les zones optiquement actives (4) sont susceptibles de générer, dans lequel la couche de protection (5) électriquement isolante absorbe le rayonnement électromagnétique (10) dans la première zone (5a), **caractérisé par** les étapes :
- réalisation d'au moins une découpe (9) dans la couche de protection (5),
- application d'une couche de raccordement (6) électriquement conductrice sur la couche de protection (5)
- création d'un deuxième contact électrique entre la couche de raccordement (6) et les au moins deux éléments voisins (3) dans la zone de l'au moins une découpe (9).

13. Procédé de fabrication (30) selon la revendication 12, **caractérisé en ce qu'**une concavité (11) est formée entre les au moins deux éléments voisins (3).
